# EUROPEAN PATENT SPECIFICATION

(11) **EP 1 650 794 B1**
(45) Date of publication and mention of the grant of the patent: **16.01.2008**
(21) Application number: 04292482.9
(22) Date of filing: 19.10.2004
(51) Int. Cl.: H01L 21/762, H01L 21/20

(54) **A method for fabricating a wafer structure with a strained silicon layer and an intermediate product of this method**
Verfahren zur Herstellung einer verspannten Silizium-Schicht auf einem Substrat und Zwischenprodukt
Méthode de fabrication d'une plaquette ayant une couche de silicium contraint et produit intermédiaire

(43) Date of publication of application: 26.04.2006
(73) Proprietor: S.O.I. Tec Silicon on Insulator Technologies S.A., 38190 Bernin (FR)
(72) Inventor: Le Vaillant, Yves-Matthieu, 38 920 Crolles (FR)
(74) Representative: Grünecker, Kinkeldey, Stockmair & Schwanhäusser Anwaltssozietät

(56) References cited:
- EP-A- 1 248 294
- WO-A-20/04019404
- US-A1- 2004 005 740

## Description

The present invention relates to a method for fabricating a wafer structure with a strained silicon layer and an intermediate product for fabricating such a wafer structure.

Fabrication of structures with a strained silicon layer are very interesting for microelectronics or optoelectronics since strained silicon layers have excellent electronic properties such as an increased carrier mobility leading to high efficiency of electronic products using such layers. Conventional methods for fabricating structures with strained silicon layers are very complex and time-consuming. In particular, it is known to grow epitaxially on a silicon substrate a SiGe buffer layer with a gradually increasing germanium content. The SiGe buffer layer is normally grown in such technologies over a relatively long period of time with only slight changes of germanium content to get at the end of this epitaxy a state on top of the SiGe layer having a dislocation density which is as low as possible. Then, a relaxed SiGe layer of a constant germanium concentration corresponding to the highest germanium concentration of the SiGe buffer layer is formed on the SiGe buffer layer. Thereafter, a strained silicon layer is formed thereon.

In this technology, the requirements to get on the one hand a high quality of strained silicon structures and to achieve on the other hand a high efficiency in production are antagonistic since for a high quality time-consuming process steps are necessary.

In another method for fabricating SGOI (silicon-germanium-on-insulator) structures, a relaxed SiGe layer formed on a silicon support substrate is split from the substrate by the so-called SmartCut® technology. Thereafter, strained epitaxial silicon is formed on the split SiGe layer. The fabrication of such SGOI layers is also time consuming and complex since the formation of the SiGe layer must be repeated for each new wafer product. That means, for each new structure at least two epitaxies are necessary.

The above technologies have the disadvantage that besides the necessary repetition of complex process steps there exists the difficulty to recycle the original substrates from which a part is split. Chemical mechanical polishing steps and/or chemical etching steps have to be applied to bring the original substrate in a state in which it can be applied once again. For recycling, the thickness of the original wafer must be considerably reduced in time-consuming steps to reduce surface roughness and to remove a step profile formed on the edge of the wafers. It is furthermore difficult to apply only chemical etching since the etching step is not selective enough in recognizing the interface between the SiGe layer with the gradual changing composition and the silicon substrate thereunder. It is therefore necessary to apply chemical mechanical polishing, complementary or as a replacement for chemical etching, which has a rather low reproducibility and efficiency.

In WO 2004 019 404 a method is described in which protecting layers such as stop layers are used to protect a layer under the recycled layer during recycling. Although such stop layers are able to protect an SiGe buffer layer on a donor or support substrate, this method cannot solve all the problems connected with the state of the art.

In particular, the SiGe buffer layer that has been subject of multiple technological steps forms a source for dislocations so that long-term epitaxies are necessary to form a new usable donor wafer and to achieve a state in which dislocation density is strongly reduced to get a good basis for a formation of a high-quality strained silicon layer.

In another approach, only a part of the relaxed SiGe layer is transferred onto another substrate and is further grown thereon to provide a good basis for a strained silicon layer. By this technology, a further formation of a buffer layer can be eliminated leading to an increased efficiency of the process and to elimination of the risk of a formation of dislocations by the buffer layer.

But, as mentioned before, a repeated SiGe epitaxy on the transferred SiGe layer is difficult to control leading to a bad efficiency of such processes. For instance, surface pre treatment of SiGe layers before SiGe epitaxial deposition is typically more difficult than strained Si deposition.

It is therefore the object of the present invention to provide a method and an intermediate product of this method which allow an efficient fabrication of a structure with a strained silicon layer wherein a donor or support substrate used in the method can be recycled with a high reproducibility.

The object is solved by a method for fabricating a wafer structure with a strained silicon layer, comprising: providing a prototype wafer comprising a support substrate, at least one insulator layer formed on the support substrate and having on top a strained silicon model layer; growing epitaxially a relaxed auxiliary SiGe layer on the strained silicon model layer; growing epitaxially a strained silicon utility layer on the auxiliary SiGe layer; and splitting the structure at a predetermined splitting area created in the auxiliary SiGe layer.

According to the inventive idea, the method for fabricating the wafer structure with a strained silicon layer comprises two main steps: the fabrication of the prototype wafer which forms a model for a utility structure and the formation of the utility structure by duplicating or cloning the characteristics of the strained silicon model layer of the prototype wafer by forming the strained silicon utility layer. Using the inventive method, the properties of the strained silicon model layer can be directly transferred to the strained silicon utility layer by using the auxiliary SiGe layer as a transmission layer between the strained silicon layers. By a simple succession of the strained silicon model layer, the auxiliary SiGe layer and the strained silicon utility layer, the strained silicon utility layer can be formed with a high quality in a very short time. It is furthermore relatively easy to split a utility structure from the prototype wafer part of the structure and to proceed thereafter with both structures separately.

According to a favourable embodiment of the present invention the method further comprises: removing a residual part of the auxiliary SiGe layer from the strained silicon utility layer after the splitting step. This step allows recycling of the split utility structure. It is very comfortable to recycle the utility structure because of the high etch selectivity between the relaxed auxiliary SiGe layer and the strained silicon utility layer.

In an advantageous example of the invention, the strained silicon model layer is further grown epitaxially before the auxiliary SiGe layer is grown thereon. The further grown strained epitaxial silicon layer is able to compensate a loss of thickness of the strained silicon layer during a recycling step, which can result from an imperfect etching selectivity.

In yet a favourable embodiment of the invention, the method further comprises: implanting the auxiliary SiGe layer to create therein the predetermined splitting area. The implantation can create a well-defined predetermined splitting area which can be split mechanically, thermally, by using shockwaves or other forces very efficiently.

According to another example of the invention, the method further comprises: bonding a second wafer on the strained silicon utility layer. The second wafer provides a good stability to the strained silicon utility layer during the splitting step and can form a good basis for the strained silicon utility layer for its further use.

It is furthermore advantageous that the method further comprises: growing of an SiGe utility layer on the strained silicon utility layer before the splitting step. This way, an SGOI (silicon-germanium-on-insulator) utility structure can be formed after the splitting step.

In another example of the invention, the method further comprises: bonding a second wafer on the SiGe utility layer. The second wafer can form a good basis of the later utility structure and can provide good stability during the splitting step.

Preferably, providing the prototype wafer comprises providing an SOI structure consisting of a silicon support substrate, at least one insulator layer and the strained silicon model layer directly on the insulator layer. This structure has only once to be produced in a conventional way as described above and can serve for many times as a model for duplicating the characteristics of the strained silicon model layer.

In another variant of the invention, providing the prototype wafer comprises providing an SGOI structure consisting of a silicon support substrate, at least one insulator layer, and an SiGe layer and a strained silicon model layer. This structure can also be formed in a conventional way wherein the strain of the strained silicon model layer is dependent on the germanium concentration of the SiGe layer. The structure has only once to be produced and can serve several times for cloning or duplicating the characteristics of a strained silicon model layer.

It is further advantageous if the method further comprises: removing a residual part of the auxiliary SiGe layer from the strained silicon model layer after the splitting step. This allows recycling of the prototype wafer after the splitting step. It is very comfortable to remove the auxiliary SiGe layer from the strained silicon model layer because there is a good etch selectivity between these layers.

The object of the invention is further solved by an intermediate product for fabricating a wafer structure with a strained silicon layer, comprising: a prototype wafer comprising a support substrate and a strained silicon model layer; a relaxed auxiliary SiGe layer on the strained silicon model layer wherein a predetermined splitting area is formed in the relaxed auxiliary SiGe layer; and a strained silicon utility layer on the auxiliary SiGe layer. The thickness of the SiGe auxiliary layer should be sufficient to incorporate the defects induced by implantation and splitting, typically > 200 nm.

In the intermediate product, the characteristics of the strained silicon model layer are directly transferred or duplicated to the strained silicon utility layer. The intermediate product forms a structure which can be easily split along the predetermined splitting area formed in the relaxed auxiliary SiGe layer so that the strained silicon utility layer can be used separately from the prototype wafer after splitting.

In yet another embodiment of the present invention, the intermediate product further comprises a second wafer bonded on the strained silicon utility layer. The second wafer can form a good support for the strained silicon utility layer during the splitting step and/or after splitting.

In another advantageous example of the invention, the intermediate product further comprises an SiGe utility layer on the strained silicon utility layer. With this structure an SGOI (silicon-germanium-on-insulator) utility structure can be formed after the splitting step.

Preferably, the intermediate product further comprises a further grown strained silicon layer between the strained silicon model layer and the auxiliary SiGe layer. The further grown strained silicon layer can help to compensate the changes in thickness of the strained silicon model layer during a recycling step of the prototype wafer.

According to a favourable variant of the invention, the prototype wafer is an SOI wafer consisting of a silicon support substrate, at least one insulator layer and the strained silicon model layer. This type of prototype wafer is only once to be formed in a conventional way and can be used thereafter several times to transfer its information from its strained silicon model layer to the strained silicon utility layer of the inventive structure.

In a yet further example of the invention, the prototype wafer is an SGOI wafer consisting of a silicon support substrate, at least one insulator layer, an SiGe layer and the strained silicon model layer. The characteristics of the strained silicon model layer of such a prototype wafer can be controlled by the germanium content of the SiGe layer of the prototype wafer. This prototype wafer has only once to be produced and can be very often used for cloning the characteristics of the strained silicon model layer by forming the strained silicon utility layer.

For a more complete understanding of this invention, one should now refer to the embodiments illustrated in greater detail in the accompanying drawings and described below by way of examples of the invention. In the drawings:
Fig. 1 is a schematic view of a prototype wafer of the present invention;
Fig. 2 is a schematic view of another prototype wafer of the present invention;
Fig. 3 shows the prototype wafer of Fig. 1 after formation of a strained silicon model layer;
Fig. 4 shows the structure of Fig. 3 after formation of a relaxed auxiliary SiGe layer;
Fig. 5 shows the structure of Fig. 4 after formation of a strained silicon utility layer;
Fig. 6 shows the structure of Fig. 5 during an implantation step;
Fig. 7 shows the structure of Fig. 6 after formation of an SiGe utility layer;
Fig. 8 shows the structure of Fig. 7 bonded onto a second wafer;
Fig. 9 shows one part of the structure of Fig. 8 after splitting;
Fig. 10 shows the structure of Fig. 9 after removal of a residual part of the former auxiliary SiGe layer;
Fig. 11 shows another split part of the structure of Fig. 8; and
Fig. 12 is a schematic view of the structure of Fig. 11 after removal of a residual part of the former auxiliary SiGe layer.

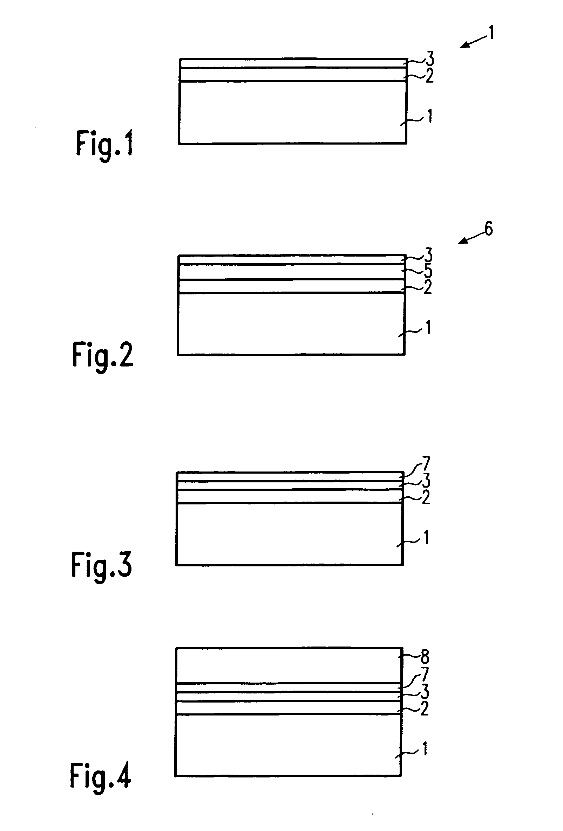

Turning now to the drawings, Fig. 1 shows schematically a view of an SOI prototype wafer 4. The prototype wafer 4 consists of a silicon substrate 1, an insulator layer 2 formed thereon and having on top a strained silicon on model layer 3. The silicon substrate 1 supports the insulator layer 2 and the strained silicon layer 3. The insulator layer 2 consists in the example shown of silicon dioxide and can comprise in other examples of the invention of silicon nitride or another insulating material or insulating materials.

The strained silicon model layer 3 has been formed on the prototype wafer, for instance by a SmartCut® process. Alternatively, the layer 3 can be formed in other examples of the invention by another method known in the art.

Fig. 2 schematically shows a view of another prototype wafer 6 consisting of a silicon substrate 1, an insulator layer 2, an SiGe layer 5 and having on top a strained silicon model layer 3. The germanium content of the relaxed SiGe layer 5 determines the strain of the strained silicon model layer 3 on top of the relaxed SiGe layer 5. The prototype wafer 6 can be formed by using the so-called SmartCut® process or by any other process known in the art.

Fig. 3 schematically shows the prototype wafer 4 of Fig. 1 after formation of a further grown strained silicon model layer 7. The characteristics of the further grown strained silicon model layer 7 are adapted onto the characteristics of the strained silicon model layer 3. The further grown strained silicon model layer 7 increases effectively the thickness of the strained silicon model layer 3 to compensate any loss of thickness during a later recycling of the prototype wafer.

Fig. 4 schematically shows the structure of Fig. 3 after formation of a relaxed auxiliary SiGe layer 8 on the further grown strained silicon model layer 7. The relaxed auxiliary SiGe layer 8 has in the example shown a constant content of germanium.

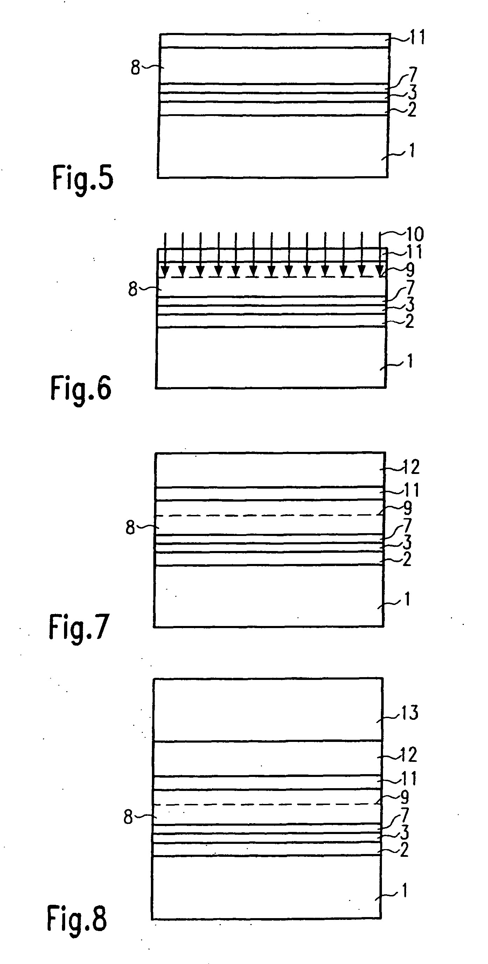

Fig. 5 schematically shows the structure of Fig. 4 after formation of a strained silicon utility layer 11 on the relaxed auxiliary SiGe layer. The strained silicon utility layer 11 has strain characteristics which are adapted on the strain characteristics of the strained silicon model layer 7. The properties of the strained silicon layers 7 and 11 are duplicated or cloned by means of the relaxed auxiliary SiGe layer between the strained silicon layers 7 and 11. Fig. 5 shows an intermediate product of the present invention consisting of the prototype wafer 4, the relaxed auxiliary SiGe layer 8 and having on top the strained silicon utility layer 11.

Fig. 6 schematically shows the structure of Fig. 5 during an implantation step in which species 10 are implanted into a certain depth of the relaxed auxiliary SiGe layer 8 forming therein a predetermined splitting area 9. At the predetermined splitting area 9 the structure of the SiGe layer is weakened so that a mechanical force, a thermal influence or shockwaves can be applied to delaminate the structure of Fig. 6 at the predetermined splitting area.

Fig. 7 schematically shows the structure of Fig. 6 after formation of an SiGe utility layer 12 on the strained silicon utility layer 11. The SiGe utility layer 12 forms later together with the strained silicon utility layer 11 at least a part of a utility structure such as an SGOI (silicon-geranium-on-insulator) utility structure.

Fig. 8 schematically shows the structure of Fig. 7 bonded on the SiGe utility layer with a second wafer 13. The second wafer 13 forms a support for the SiGe utility layer 12 and the strained silicon utility layer 11 during splitting of the structure of Fig. 8 and is thereafter a good carrier for the SiGe utility layer 12 and the strained silicon utility layer 11.

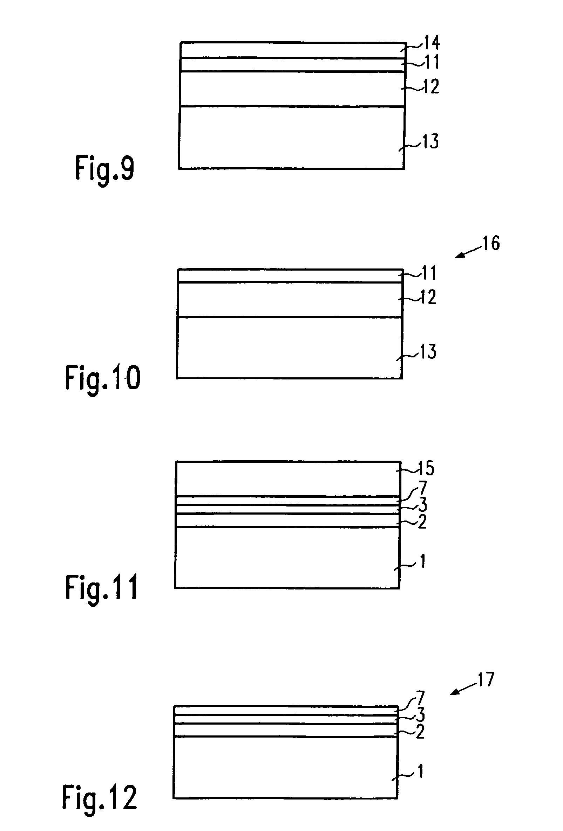

The structure of Fig. 8 is split after the bonding step, for instance by a mechanical force, by a thermal influence, by shockwaves or by a combination of such influences. The structure of Fig. 8 is split along the predetermined splitting area 9 resulting in the structures shown in Fig. 9 or Fig. 11.

Fig. 9 schematically shows one split part of the structure of Fig. 8 after the splitting step. The first split part consists of the second wafer 13, the SiGe utility layer 12, the strained silicon utility layer 11 and a residual part 14 of the former relaxed auxiliary SiGe layer 8. Although the surface of the residual part 14 shown in Fig. 9 is relatively flat, the surface can be very rough. It is therefore advantageous to flatten at least the surface of the residual part 14. The removal of the rough surface structure can be made with a chemical mechanical polishing step or by selective chemical etching or by a combination of these means.

Fig. 10 schematically shows the structure of Fig. 9 after removal of the residual part 14 of the former relaxed auxiliary SiGe layer 8. The residual part 14 is removed in the example shown by a chemical etching step using the high selectivity of about 1:30 between the material of the former relaxed auxiliary SiGe layer 8 and the strained silicon utility layer 11, for instance by using a CH3COOH/H2O2/H2O solution with respective concentration of 4/3/0.25 or NH4OH/H2O2/H2O) solution with respective concentration of 1/1/5.

Fig. 11 schematically shows a second part of the structure of Fig. 8 after splitting. The structure of Fig. 11 consists of the silicon support substrate 1, the insulator layer 2, the strained silicon model 3, the further grown strained silicon model layer 7 and a residual part 15 of the former relaxed auxiliary SiGe layer 8. As mentioned above with reference to the residual part 14, the surface of the residual part 15 can also be relatively rough so that recycling of at least the surface of this layer 15 is necessary.

Fig. 12 schematically shows the structure of Fig. 11 after a recycling step in which the residual part 15 of the former relaxed auxiliary SiGe layer 8 is removed. The residual part 15 is preferably removed by a selective chemical etching step using the high etch selectivity of the material of the former relaxed auxiliary SiGe layer 8 and the further grown strained silicon model layer 7 of about 1:30. The structure of Fig. 12 can then again be used for forming a new relaxed auxiliary SiGe layer thereon as shown in Fig. 4 to repeat the whole process of duplicating the characteristics of the strained silicon model layer 3.

Although the steps of the inventive method shown in Figs. 3 to 12 are shown and described to be performed on the prototype wafer 4 of Fig. 1, these steps can also be applied on the prototype wafer 6 of Fig. 2 or on another prototype wafer having at least a support substrate and strained silicon layer which can be used as strained silicon model layer in the sense of the present invention.

## Claims

1. A method for fabricating a wafer structure with a strained silicon layer, comprising:
providing a prototype wafer (4,6) comprising a support substrate (1), at least one insulator layer (2) formed on the support substrate (1) and having on top a strained silicon model layer (3);
growing epitaxially a relaxed auxiliary SiGe layer (8) on the strained silicon model layer (3);
growing epitaxially a strained silicon utility layer (11) on the auxiliary SiGe layer (8); and
splitting the structure at a predetermined splitting area (9) created in the auxiliary SiGe layer (8).

2. The method of claim 1, **characterized in that** the method further comprises:
removing a residual part of the auxiliary SiGe layer (8) from the strained silicon utility layer (11) after the splitting step.

3. The method of claim 1 or 2, **characterized in that** the strained silicon model layer (3) is further grown epitaxially before the auxiliary SiGe layer (8) is grown thereon.

4. The method of one of the preceding claims, **characterized in that** the method further comprises:
implanting the auxiliary SiGe layer (8) to create therein the predetermined splitting area (9).

5. The method of one of the preceding claims, **characterized in that** the method further comprises:
bonding a second wafer onto the strained silicon utility layer (11).

6. The method of one of the claims 1 to 4 **characterized in that** the method further comprises:
growing of a SiGe utility layer (12) on the strained silicon utility layer (11) before the splitting step.

7. The method of claim 6 **characterized in that** the method further comprises:
bonding a second wafer onto the SiGe utility layer (12).

8. The method of one of the preceding claims, **characterized in that** providing the prototype wafer (6) comprises providing an SOI structure consisting of a silicon support substrate (1), at least one insulator layer (2) and the strained silicon model layer (3) directly on the insulator layer (2).

9. The method of one of the claims 1 to 7 **characterized in that** providing the prototype wafer (6) comprises providing an SGOI structure consisting of a silicon support substrate (1), at least one insulator layer (2), an SiGe layer (5) and the strained silicon model layer (3).

10. The method of one of the preceding claims **characterized in that** the method further comprises:
removing a residual part of the auxiliary SiGe layer (8) from the strained silicon model layer (3) after the splitting step.

11. An intermediate product for fabricating a water structure with a strained silicon layer, comprising:
a prototype wafer (4, 6) comprising a support substrate (1), at least one insulator layer (2) formed on the support substrate (1) and a strained silicon model layer (3);
a relaxed auxiliary SiGe layer (8) on the strained silicon model layer (3) wherein a predetermined splitting area (9) is formed in the relaxed auxiliary SiGe layer (8); and
a strained silicon utility layer (11) on the auxiliary SiGe layer (8).

12. The intermediate product of claim 11 **characterized in that** the intermediate product further comprises an SiGe utility layer (12) on the strained silicon utility layer (11).

13. The intermediate product of claim 11 or 12 **characterized in that** the intermediate product further comprises a second wafer (13) bonded on the strained silicon utility layer (11) or on the SiGe utility layer (12).

14. The intermediate product of one of the claims 11 to 13 **characterized in that** the intermediate product further comprises a further grown strained silicon model layer (7) between the strained silicon model layer (3) and the auxiliary SiGe layer (8).

15. The intermediate product of one of the claims 11 to 14 **characterized in that** the prototype wafer (4) is an SOI wafer consisting of a silicon support substrate (1), at least one insulator layer (2) and the strained silicon model layer (3).

16. The intermediate product of one of the claims 11 to 14 **characterized in that** the prototype wafer (6) is an SGOI wafer consisting of a silicon support substrate (1), at least one insulator layer (2), an SiGe layer and the strained silicon model layer (3).

## Patentansprüche

1. Verfahren zur Herstellung einer Waferstruktur mit einer verspannten Siliziumschicht (strained silicon layer), umfassend:
Bereitstellen eines Prototyp-Wafers (4, 6), welcher ein Trägersubstrat (1) umfasst, wenigstens eine Isolierschicht (2), welche auf dem Trägersubstrat (1) gebildet ist und welche auf der Oberseite eine verspannte Siliziummusterschicht (silicon model layer) (3) aufweist;
Epitaktisches Aufwachsen einer entspannten (relaxed) SIGe-Hilfsschicht (8) auf der verspannten Siliziummusterschicht (3);
Epitaktisches Aufwachsen einer verspannten Siliziumnutzschicht (11) auf der SiGe-Hilfsschicht (8) und
Spalten der Struktur an einer vorbestimmten Spaltfläche (9), welche in der SiGe-Hilfsschicht (8) erzeugt wird.

2. Verfahren nach Anspruch 1, **dadurch gekennzeichnet, dass** das Verfahren des weiteren umfasst: Entfernen eines restlichen Teils der SiGe-Hilfsschicht (8) von der verspannten Siliziumnutzschicht (11) nach dem Spaltungsschritt.

3. Verfahren nach Anspruch 1 oder 2, **dadurch gekennzeichnet, dass** die verspannte Siliziummusterschicht (3) des weiteren epitaktisch aufgewachsen wird, bevor die SiGe-Hilfsschicht (8) darauf aufwächst.

4. Verfahren nach einem der vorangehenden Ansprüche, **dadurch gekennzeichnet, dass** das Verfahren des weiteren umfasst: Implantieren der SiGe-Hilfsschicht (8), um darin die vorbestimmte Spaltfläche (9) zu erzeugen.

5. Verfahren nach einem der vorangehenden Ansprüche, **dadurch gekennzeichnet, dass** das Verfahren des weiteren umfasst: Bonden eines zweiten Wafers an die verspannte Siliziumnutzschicht (11).

6. Verfahren nach einem der Ansprüche 1 bis 4, **dadurch gekennzeichnet, dass** das Verfahren des weiteren umfasst: Aufwachsen einer SiGe-Nutzschicht (12) auf der verspannten Siliziumnutzschicht (11) vor dem Spaltschritt.

7. Verfahren nach Anspruch 6, **dadurch gekennzeichnet, dass** das Verfahren des weiteren umfasst: Bonden eines zweiten Wafers an die SiGe-Nutzschicht (12).

8. Verfahren nach einem der vorangehenden Ansprüche, **dadurch gekennzeichnet, dass** das Bereitstellen des Prototyp-Wafers (6) das Bereitstellen einer SOI-Strukur umfasst, bestehend aus einem Siliziumträgersubstrat (1), wenigstens einer Isolatorschicht (2) und der verspannten Siliziummusterschicht (3) direkt auf der Isolatorschicht (2).

9. Verfahren nach einem der Ansprüche 1 bis 7, **dadurch gekennzeichnet, dass** das Bereitstellen des Prototyp-Wafers (6) das Bereitstellen einer SGOI-Struktur umfasst, bestehend aus einem Siliziumträgersubstrat (1), wenigstens einer Isolatorschicht (2), einer SiGe-Schicht (5) und der verspannten Siliziummusterschicht (3).

10. Verfahren nach einem der vorangehenden Ansprüche, **dadurch gekennzeichnet, dass** das Verfahren des weiteren umfasst: Entfernen eines restlichen Teils der SiGe-Hilfsschicht (8) von der verspannten Siliziummusterschicht (3) nach dem Spaltschritt.

11. Zwischenprodukt zur Herstellung einer Wafer-Struktur mit einer verspannten Siliziumstruktur, umfassend:
einen Prototyp-Wafer (4, 6) umfassend ein Trägersubstrat (1), wenigstens eine Isolatorschicht (2), gebildet auf dem Trägersubstrat (1) und eine verspannte Siliziummusterschicht (3);
eine entspannte SiGe-Hilfsschicht (8) auf der verspannten Siliziummusterschicht (3), wobei eine vorbestimmte Spaltfläche (9) in der entspannten SiGe-Hilfsschicht (8) gebildet ist; und
eine verspannte Siliziumnutzschicht (11) auf der SiGe-Hilfsschicht (8).

12. Zwischenprodukt nach Anspruch 11, **dadurch gekennzeichnet, dass** das Zwischenprodukt des weiteren eine SiGe-Nutzschicht (12) auf der verspannten Siliziumnutzschicht (11) umfasst.

13. Zwischenprodukt nach Anspruch 11 oder 12, **dadurch gekennzeichnet, dass** das Zwischenprodukt des weiteren einen zweiten Wafer (13) umfasst, welcher an die verspannte Siliziumnutzschicht (11) oder an die SiGe-Nutzschicht (12) gebondet ist.

14. Zwischenprodukt nach einem der Ansprüche 11 bis 13, **dadurch gekennzeichnet, dass** das Zwischenprodukt des weiteren eine weitere aufgewachsene verspannte Siliziummusterschicht (7) zwischen der verspannten Siliziummusterschicht (3) und der SiGe-Hilfsschicht (8) umfasst.

15. Zwischenprodukt nach einem der Ansprüche 11 bis 14, **dadurch gekennzeichnet, dass** der Prototyp-Wafer (4) ein SOI-Wafer ist, bestehend aus einem Siliziumträgersubstrat (1), wenigstens einer Isolatorschicht (2) und der verspannten Siliziummusterschicht (3).

16. Zwischenprodukt nach einem der Ansprüche 11 bis 14, **dadurch gekennzeichnet, dass** der Prototyp-Wafer (6) ein SGOI-Wafer ist, bestehend aus einem Siliziumträgersubstrat (1), wenigstens einer Isolatorschicht (2), einer SiGe-Schicht und der verspannten Siliziummusterschicht (3).

## Revendications

1. Procédé de fabrication d'une structure de plaquette comportant une couche de silicium contraint, comprenant :
la fourniture d'une plaquette prototype (4, 6) comprenant un substrat support (1), au moins une couche isolante (2) formée sur le substrat support (1) et couverte d'une couche modèle de silicium contraint (3) ;
la croissance épitaxiale d'une couche auxiliaire de SiGe non contraint (8) sur la couche modèle de silicium contraint (3) ;
la croissance épitaxiale d'une couche utilitaire de silicium contraint (11) sur la couche auxiliaire de SiGe (8) ; et
la séparation de la structure au niveau d'une zone de séparation prédéterminée (9) créée dans la couche auxiliaire de SiGe (8).

2. Procédé selon la revendication 1, **caractérisé en ce que** le procédé comprend en outre :
l'élimination d'une partie résiduelle de la couche auxiliaire de SiGe (8) à partir de la couche utilitaire de silicium contraint (11) après l'étape de séparation.

3. Procédé selon la revendication 1 ou 2, **caractérisé en ce qu'**on fait croître en outre de manière épitaxiale la couche modèle de silicium contraint (3) avant de faire croître la couche auxiliaire de SiGe (8) sur celle-ci.

4. Procédé selon l'une quelconque des revendications précédentes, **caractérisé en ce que** le procédé comprend en outre :
l'implantation de la couche auxiliaire de SiGe (8) pour créer dans celle-ci la zone de séparation prédéterminée (9).

5. Procédé selon l'une quelconque des revendications précédentes, **caractérisé en ce que** le procédé comprend en outre :
le collage d'une seconde plaquette sur la couche utilitaire de silicium contraint (11).

6. Procédé selon l'une quelconque des revendications 1 à 4, **caractérisé en ce que** le procédé comprend en outre :
la croissance d'une couche utilitaire de SiGe (12) sur la couche utilitaire de silicium contraint (11) avant l'étape de séparation.

7. Procédé selon la revendication 6, **caractérisé en ce que** le procédé comprend en outre :
le collage d'une seconde plaquette sur la couche utilitaire de SiGe (12).

8. Procédé selon l'une quelconque des revendications précédentes, **caractérisé en ce que** la fourniture de la plaquette prototype (6) comprend la fourniture d'une structure SOI constituée par un substrat support en silicium (1), au moins une couche isolante (2) et la couche modèle de silicium contraint (3) directement sur la couche isolante (2).

9. Procédé selon l'une quelconque des revendications 1 à 7, **caractérisé en ce que** la fourniture de la plaquette prototype (6) comprend la fourniture d'une structure SGOI constituée par un substrat support en silicium (1), au moins une couche isolante (2), une couche de SiGe (5) et la couche modèle de silicium contraint (3).

10. Procédé selon l'une quelconque des revendications précédentes, **caractérisé en ce que** le procédé comprend en outre :
l'élimination d'une partie résiduelle de la couche auxiliaire de SiGe (8) à partir de la couche modèle de silicium contraint (3) après l'étape de séparation.

11. Produit intermédiaire pour la fabrication d'une structure de plaquette comportant une couche de silicium contraint, comprenant :
une plaquette prototype (4, 6) comprenant un substrat support (1), au moins une couche isolante (2) formée sur le substrat support (1) et une couche modèle de silicium contraint (3) ;
une couche auxiliaire de SiGe non contraint (8) sur la couche modèle de silicium contraint (3), dans laquelle une zone de séparation prédéterminée (9) est formée dans la couche auxiliaire de SiGe non contraint ; et
une couche utilitaire de silicium contraint (11) sur la couche auxiliaire de SiGe (8).

12. Produit intermédiaire selon la revendication 11, **caractérisé en ce que** le produit intermédiaire comprend en outre une couche utilitaire de SiGe (12) sur la couche utilitaire de silicium contraint (11).

13. Produit intermédiaire selon la revendication 11 ou 12, **caractérisé en ce que** le produit intermédiaire comprend en outre une seconde plaquette (13) collée sur la couche utilitaire de silicium contraint (11) ou sur la couche utilitaire de SiGe (12).

14. Produit intermédiaire selon l'une quelconque des revendications 11 à 13, **caractérisé en ce que** le produit intermédiaire comprend en outre une couche modèle de silicium contraint (7) qu'on a fait croître en outre entre la couche modèle de silicium contraint (3) et la couche auxiliaire de SiGe (8).

15. Produit intermédiaire selon l'une quelconque des revendications 11 à 14, **caractérisé en ce que** la plaquette prototype (4) est une plaquette SOI constituée par un substrat support en silicium (1), au moins une couche isolante (2) et la couche modèle de silicium contraint (3).

16. Produit intermédiaire selon l'une quelconque des revendications 11 à 14, **caractérisé en ce que** la plaquette prototype (6) est une plaquette SGOI constituée par un substrat support en silicium (1), au moins une couche isolante (2), une couche de SiGe et la couche modèle de silicium contraint (3).
